# EUROPÄISCHE PATENTSCHRIFT

(11) **EP 0 363 525 B1**
(45) Veröffentlichungstag und Bekanntmachung des Hinweises auf die Patenterteilung: **22.12.1993**
(21) Anmeldenummer: 88117265.4
(22) Anmeldetag: 17.10.1988
(51) Int. Cl.: G06F 15/70, H01L 21/00, G01B 11/00

(54) **Verfahren zur zweidimensionalen Lage- und Orientierungserkennung von vorher bekannten Körpern**
Method of recognising the two-dimensional position and orientation of already known objects
Méthode de reconnaissance de la position et de l'orientation bidimensionnelle d'objets déjà connus

(43) Veröffentlichungstag der Anmeldung: 18.04.1990
(73) Patentinhaber: SIEMENS AKTIENGESELLSCHAFT, 80333 München (DE)
(72) Erfinder: Brendes, Martin, Dipl.-Ing., D-3300 Braunschweig (DE); Doemens, Günter, Dr. Ing., D-8015 Holzkirchen (DE); Mengel, Peter, Dr. rer. nat., D-8031 Eichenau (DE)

(56) Entgegenhaltungen:
- WO-A-87/03719
- US-A- 4 593 406
- US-A- 4 695 982
- US-A- 4 766 556
- IEEE TRANSACTIONS ON PATTERN ANALYSIS AND MACHINE INTELLIGENCE, Band PAMI-6, Nr. 4, Juli 1984, Seiten 430-441, IEEE, New York, US; B. CERNUSCHI-FRIAS et al.: "3-D space location and orientation parameter estimation of Lambertian spheres and cylinders from a single 2-D image by fitting lines and ellipses to thresholded data"
- OPTICS COMMUNICATIONS, Band 36, Nr. 6, 15. März 1981, Seiten 439-440, Amsterdam, NL; H.J. CAULFIELD: "Centroid detectors in metrology"

## Beschreibung

Für die autmatisierte Bildverarbeitung wird in der Regel der Vergleich zwischen aktuell aufgenommenen Bilddaten und gespeicherten Informationen durchgeführt. Die zu verarbeitenden Bilder bestehen im Gegensatz zur Grauwertbildverarbeitung aus dreidimensional aufgenommenen Abstandsdaten, die üblicherweise mittels der Triangulation und durch den Einsatz von einem oder mehreren 3D-Sensoren (dreidimensional aufnehmender Sensor) und einem Laser-Scanner erzielt werden. Hierbei ist die direkte und vollständige Erfassung eines Werkstückes möglich. Die Information im allgemeinen karthesischen Koordinatensystem X, Y, Z besteht in der Höhenangabe Z für jeden einzelnen aufgenommenen Punkt. Nach der Beziehung Z = f (X, Y). Die hauptsächlichen Probleme derartiger Verfahren liegen darin, eine hohe Erfassungsgeschwindigkeit zu erreichen und unabhängig von den optischen Eigenschaften der Werkstückoberflächen zu sein. Um das nicht zu vermeidende Rauschen bei der Bildaufnahme, was zu lokalen Bildstörungen führt, auszuschalten wurde die Auswertung von dreidimensional aufgenommenen Abstandsbildern bereits mittels globaler Merkmale durchgeführt. In der EP-A-0355377 wird beschrieben, daß nicht einzelne Bildpunkte, die durch Fehlmessungen verfälscht sein können, zur Auswertung herangezogen werden, sondern daß zumindest eine größere Teilmenge oder abgeleitete für den Körper charakteristische Größen zu dessen Identifizierung herangezogen werden. Praktische Anwendungen dieser Verfahren gibt es beispielsweise bei der Robotersteuerung oder bei der Prüfung von bestückten Leiterplatten. Die Anwendung bezüglich der Lage- und Orientierungserkennung an industriellen Objekten im Raum oder in der Ebene durch ein Verfahren auf der Basis von dreidimensionalen Bilddaten ist nicht bekannt.

Der Erfindung liegt die Aufgabe zugrunde, ein Verfahren zur zweidimensionalen Lage- und Orientierungsbestimmung auf der Grundlage von dreidimensional aufgenommenen Bilddaten zur Verfügung zu stellen, wobei eine wesentliche Datenreduzierung für die Vergleichsoperationen und eine hohe Erkennungssicherheit beinhaltet sein sollen.

Die Lösung dieser Aufgabe wird durch die Merkmale des Anspruches 1 wiedergegeben.

Der Erfindung liegt die Erkenntnis zugrunde, daß eine wesentliche Datenreduktion bei Vergleichsoperationen zur zweidimensionalen Erkennung von Lage und Orientierung bekannter Körper durch die Schnittbildung des Meßobjektes mit einem Volumenprimitiv erzielbar ist, wobei jeweils die Schnittkurven zwischen Meßobjekt und Volumenprimitiv verglichen werden mit den Schnittkurven, die in Form von abgespeicherten Werten einer Referenzlage vorliegen. Somit werden durch relativ wenige aufzunehmende charakteristische Merkmale des bekannten Körpers, die durch die Schnittbildung entstehen, Teilmengen der aufgenommenen Bilddaten für die Vergleichsoperationen herangezogen, während der überwiegende Teil der aufgenommenen Bilddaten gelöscht werden kann. Aus der ebenen Betrachtung dieser Problemlösung folgt, daß lediglich die Lage eines ausgewählten Punktes des Meßobjektes, eines bekannten Körpers, festgelegt oder berechnet werden muß und dann der eben, in der x,y-Ebene, liegende bekannte Körper sich in einer zu erkennenden Lage, die sich um den Drehwinkel φ von einer Referenzlage unterscheidet, befindet.

Eine besonders vorteilhafte Ausgestaltung der Erfindung sieht vor, daß als Volumenprimitiv ein Kreiszylinder eingesetzt wird. Durch die Schnittbildung mit diesem Kreiszylinder werden von der Drehung des bekannten Körpers in der x,y-Ebene um einen vorbestimmten Punkt herum von der Form her relativ einfache Schnittlinien erzeugt.

Eine weitere vorteilhafte Ausgestaltung der Erfindung sieht vor, daß die Achse des Kreiszylinders senkrecht auf der x,y-Ebene steht.

Wird als vorbestimmter Punkt der Volumenschwerpunkt des bekannten Körpers, der anhand der Oberflächendaten errechnet werden kann, verwendet, so ist in einfacher Weise die Lageabweichung von einer Referenzlage ermittelbar und anschließend durch Vergleich der Schnittlinien die Orientierung des bekannten Körpers bezüglich der Referenzlage erkennbar.

Im folgenden wird anhand einer Figur ein Ausführungsbeispiel beschrieben.

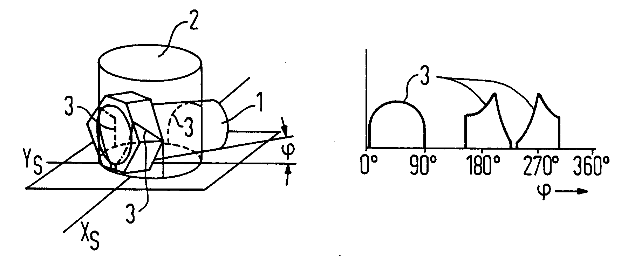

In der Figur sind bezogen auf eine Schnittbildung zwischen dem bekannten Körper 1, hier eine Schraube, und dem virtuellen Volumenprimitiv 2, hier ein Kreiszylinder, die Schnittlinien 3 in ihrer tatsächlichen Form und in der relativ zum Vollkreis abgewickelten Darstellung skizziert. Die Schnittlinien 3 sind in diesem ganz speziellen Fall, wo der Volumenschwerpunkt des bekannten Körpers 1 auf der Achse des Kreiszylinders zum Liegen kommt, in ihrer Form nicht abhängig von der Drehung des bekannten Körpers 1. Die Abhängigkeit der Lage der Schnittlinien von dem Drehwinkel φ gibt jedoch eine eindeutige Erkennung der Orientierung des bekannten Körpers 1 an.

Für mögliche industrielle Anwendungsfälle ist diese zweidimensionale Lage- und Orientierungserkennung von vorher bekannten Körpern 1 völlig ausreichend. Die Verwendung eines Kreiszylinders der in einer Zwangslage mit dem Meßobjekt, einem bekannten Körper 1, geschnitten wird, bedeutet eine Einschränkung der Freiheitsgrade. Es sind in diesem Fall als Variable lediglich die Koordinaten X und Y und der Drehwinkel φ zu betrachten. Damit läßt sich eine schnelle Erkennung von Körpern in der Ebene durchführen.

## Patentansprüche

1. Verfahren zur maschinellen Ermittlung von zweidimensionalen Lage- und Orientierungswerten von vorher bekannten Körpern (1) anhand von dreidimensionalen Bilddaten, die in Form von über dreidimensional aufnehmende Sensoren ermittelten Höhenrasterbildern, die aus einer Vielzahl von gemessenen Oberflächenpunkten bestehen, vorliegen, und in einer Rechenanlage gespeichert werden, bei dem
- eine Schnittbildung zwischen der Oberfläche des bekannten Körpers (1) und der Oberfläche eines ebenfalls gespeicherten virtuellen Volumenprimitives (2) errechnet wird, wobei
ein vorbestimmter Punkt des bekannten Körpers (1) auf eine Symmetrieachse des virtuellen Volumenprimitives (2) zum Liegen kommt oder mit dessen Symmetriezentrum zusammenfällt,
- die Lage- und Orientierungswerte des bekannten Körpers (1) als Meßobjekt mit den Lage- und Orientierungswerten des bekannten Körpers (1) in einer Referenzlage verglichen werden, wobei jeweils eine Schnittbildung vorliegt und die Schnittlinien (3) zum Vergleich herangezogen werden und
- aus den Lage- und Orientierungswerten nach dem Vergleich mit denen der Referenzlage der vorbestimmte Punkt auf der Oberfläche des Meßobjektes ermittelt wird und die Lage des Meßobjektes relativ zu der Referenzlage errechnet wird.

2. Verfahren nach Anspruch 1,
**dadurch gekennzeichnet,**
daß das virtuelle Volumenprimitiv (2) ein Kreiszylinder ist.

3. Verfahren nach Anspruch 2,
**dadurch gekennzeichnet,**
daß der Kreiszylinder bezüglich der zweidimensionalen Lage- und Orientierungserkennung senkrecht steht.

4. Verfahren nach einem der vorhergehenden Ansprüche,
**dadurch gekennzeichnet,**
daß der vorbestimmte Punkt der Volumenschwerpunkt die Koordinaten (Xₛ,Yₛ) des bekannten Körpers (1) ist.

## Claims

1. Method for the mechanical determination of two-dimensional position and orientation values of already known objects (1) with reference to three-dimensional image data which are available in the form of elevation raster images which are determined by means of three dimensionally recording sensors and which comprise a plurality of measured surface points, and are stored in a computer system, in which method
- a section formation is computed between the surface of the known object (1) and the surface of a likewise stored virtual volume pattern (2),
a predetermined point of the known object (1) coming to lie on an axis of symmetry of the virtual volume pattern (2) or coinciding with its centre of symmetry,
- the position and orientation values of the known object (1) as measurement object are compared with the position and orientation values of the known object (1) in a reference position, in each instance a section formation being present and the lines of intersection (3) being utilised for the comparison, and
- the predetermined point on the surface of the measurement object is determined and the position of the measurement object relative to the reference position is computed from the position and orientation values following the comparison with those of the reference position .

2. Method according to Claim 1, characterised in that the virtual volume pattern (2) is a circular cylinder.

3. Method according to Claim 2, characterised in that the circular cylinder is at right angles to the two dimensional position and orientation recognition.

4. Method according to one of the preceding claims, characterised in that the predetermined point is the volume centre of gravity with the coordinates (Xₛ, Yₛ) of the known object (1).

## Revendications

1. Procédé de détermination automatisé de valeurs bidimensionnelles de position et d'orientation d'objets déjà connus (1), sur la base de données d'image tridimensionnelles, qui sont présentes sous la forme d'images de trame en hauteur, qui sont fournies par l'intermédiaire de capteurs réalisant une détection en trois dimensions, qui sont constituées d'une multiplicité de points mesurés de la surface, et sont mémorisées dans une installation de calcul, et selon lequel
- une image de coupe entre la surface de l'objet connu (1) et la surface d'une forme primitive virtuelle de volume (2) également mémorisée est calculée,
un point préscrit de l'objet connu (1) vient s'appliquer sur un axe de symétrie de la forme primitive virtuelle de volume (2) ou coïncide avec le centre de symétrie de cette forme primitive,
- les valeurs de position et d'orientation de l'objet connu (1) sont comparées en tant qu'objet de mesure aux valeurs de position et d'orientation de l'objet connu (1) dans une position de référence, en obtenant respectivement une coupe, et les lignes de coupe (3) sont utilisées pour la comparaison, et
- le point préscrit à la surface de l'objet de mesure est déterminé à partir des valeurs de position et d'orientation par la comparaison de ces valeurs à celles correspondant à la position de référence, et la position de l'objet de mesure par rapport à la position de référence est calculée.

2. Procédé suivant la revendication 1, caractérisé par le fait que la forme primitive virtuelle de volume (2) est un cylindre à base circulaire.

3. Procédé suivant la revendication 2, caractérisé par le fait que le cylindre à base circulaire est perpendiculaire par rapport à la reconnaissance bidimensionnelle de position et d'orientation.

4. Procédé suivant l'une des revendications précédentes, caractérisé par le fait que le point préscrit est le centre de gravité du volume de coordonnées (Xₛ, Yₛ) de l'objet connu (1).
